# FASCICULE DE BREVET EUROPEEN

(11) **EP 0 586 273 B1**
(45) Date de publication et mention de la délivrance du brevet: **17.06.1998**
(21) Numéro de dépôt: 93401964.7
(22) Date de dépôt: 28.07.1993
(51) Int. Cl.: H02H 3/38, H02H 3/50, G01R 29/16

(54) **Dispositif détecteur de défauts sur un réseau de distribution d'énergie électrique aérien**
Detektionsvorrichtung für Fehler auf einem Freileitungsnetz für elektrische Energieverteilung
Detector device for faults on an electric energy distributing aerial network

(30) Priorité: 31.07.1992 FR 9209549
(43) Date de publication de la demande: 09.03.1994
(73) Titulaire: ELECTRICITE DE FRANCE Service National, 75008 Paris (FR)
(72) Inventeur: Bergeal, Jean, F-91120 Palaiseau (FR); Raymongue, Jacques, F-78190 Trappes (FR)
(74) Mandataire: Polus, Camille

(56) Documents cités:
- EP-A- 69 790
- EP-A- 267 500
- EP-A- 398 396
- DE-A- 4 135 425
- FR-A- 2 616 549

## Description

La présente invention concerne les réseaux de distribution d'énergie électrique aériens et, en particulier les réseaux dénommés HTA, c'est-à-dire dont la tension est inférieure ou égale à 50kV.

Un nouveau régime de neutre (compensation) est mis en oeuvre sur ce type de réseaux afin de limiter les courants de défauts à des valeurs beaucoup moins élevées. De ce fait, les détecteurs de défauts actuellement utilisés basés sur un principe uniquement ampéremétrique ne peuvent plus détecter des défauts à la terre.

Par ailleurs, en ce qui concerne les lignes aériennes, les dispositifs de détection de défauts utilisés actuellement ne peuvent pas détecter correctement les défauts polyphasés, c'est-à-dire les défauts à la terre concernant plusieurs phases.

On connaît en particulier des dispositifs détecteur de défauts du type wattmétrique dans lesquels on mesure et on surveille la puissance homopolaire de la ligne à surveiller. Ces dispositifs nécessitent d'être alimentés à travers des capteurs précis et fiables (la précision doit être de l'ordre du degré en ce qui concerne la phase) et à large bande passante (par exemple de 25 à 1000Hz). Il en résulte que ces dispositifs wattmétriques, pour être utilisés de manière fiable, doivent être alimentés à travers des capteurs très précis, non disponibles en général en réseau.

On connaît par ailleurs des dispositifs de détection des défauts qui comportent un circuit électronique qui reçoit un signal représentatif de la tension homopolaire et un signal représentatif du courant homopolaire de la ligne à surveiller et qui effectue une détection directionnelle des défauts en analysant les variations transitoires du courant homopolaire et de la tension homopolaire ( leur signe ).

En effet, sur le départ en défaut, le courant transitoire homopolaire est de signe opposé aux courants transitoires homopolaires des départs sains. De plus la variation instantanée de la tension homopolaire se fait dans le même sens que la variation de courant sur les départs sains. La détection s'effectuant sur les composantes transitoires, on effectue alors un filtrage afin d'éliminer la composante principale à 50Hz du courant homopolaire.

Ces détecteurs de type à détection du courant homopolaire transitoire sont alimentés par des transformateurs fournissant la tension homopolaire et par des tores fournissant le courant homopolaire, c'est à dire les capteurs précis et fiables mentionnés précédemment. Pour des questions d'isolement, ils ne peuvent donc être utilisés sur des lignes aériennes.

On connaît en particulier d'après EP-0 267 500, un procédé de localisation d'une liaison à la terre d'un conducteur dans un réseau triphasé selon lequel à un emplacement de mesure du réseau, on obtient à l'aide d'un capteur de courant, un premier signal de mesure représentant le courant somme et à l'aide d'un capteur de tension, un second signal de mesure représentant la tension de décalage d'un point du réseau, on détermine une réponse de direction d'après la relation de phase des transitoires des signaux de mesure passant par la liaison à la terre, au moins l'un des deux signaux de mesure étant réduit à sa partie stationnaire.

On connaît par ailleurs d'après FR-A-2 616 549, un dispositif pour détecter et mesurer les défauts de transmission d'énergie électrique dans les lignes aériennes polyphasées équilibrées, comportant des conducteurs alignés sensiblement dans un même plan, par détection des champs électromagnétiques créés à proximité de la ligne par les courants qui y circulent, ce dispositif comprenant un système d'antenne formé par deux antennes perpendiculaires l'une à l'autre et disposées dans un même plan transversal à la ligne aérienne, l'une de ces antennes étant parallèle au plan d'alignement des conducteurs et l'autre étant perpendiculaire à ce plan d'alignement, chaque antenne étant reliée par un amplificateur à un bloc électronique.

On connaît enfin d'après EP-0 398 396, un capteur de tension pour détecter une tension sur un objet chargé électriquement tel qu'une ligne de distribution ou analogue, le capteur étant disposé avec un espace d'isolation par rapport à l'objet.

Le capteur de tension comprend un circuit amplificateur pour délivrer un signal ayant une forme d'onde semblable à celle d'un courant de décalage provenant de l'objet chargé électriquement par l'intermédiaire de l'espace d'isolation et un circuit de filtrage pour extraire un signal ayant des fréquences prédéterminées de la sortie de l'amplificateur et délivrer une forme d'onde en courant alternatif semblable au potentiel de l'objet chargé électriquement.

La présente invention a pour but de créer un dispositif de détection de défauts sur un réseau de distribution d'énergie électrique aérien qui permet de détecter de manière fiable les défauts même sur les réseaux comportant le nouveau régime de neutre et qui permet également de détecter de manière fiable les défauts polyphasés.

A cet effet, l'invention a pour objet un dispositif de détection de défauts sur un réseau de distribution d'énergie électrique aérien comportant un circuit électronique qui reçoit un signal représentatif de la tension homopolaire et un signal représentatif du courant homopolaire de la ligne à surveiller, ledit circuit électronique effectuant une détection des variations transitoires du courant homopolaire en comparant le signe de la variation transitoire du courant homopolaire à celui de la variation transitoire de la tension homopolaire, **caractérisé en ce que** le capteur de courant homopolaire est constitué par une bobine comportant un noyau magnétique et disposée sous la ligne à surveiller perpendiculairement à celle-ci, sur un axe horizontal, en ce que le signal fourni par cette bobine est envoyé sur un circuit intégrateur et en ce que le capteur de tension est constitué par un capteur de champ électrique réalisé sur un circuit imprimé et disposé sous la ligne, le capteur de champ électrique permettant seulement de mesurer une composante liée au déséquilibre géometrique de la ligne.

L'utilisation d'une bobine montée sur un barreau magnétique permet de capter de façon aisée et peu coûteuse un signal qui est en fait proportionnel à l'induction créée par la ligne; le signal obtenu à la sortie du circuit intégrateur est donc significatif du courant homopolaire. Ce signal présente une précision suffisante pour alimenter un dispositif de détection à surveillance des variations transitoires du courant homopolaire.

Le signal représentatif de la tension est également obtenu de manière simple au moyen d'un capteur de champ électrique, ce qui exclut l'usage de transformateur. Selon un mode de réalisation particulier de l'invention, on prévoit un deuxième capteur de courant homopolaire constitué par une deuxième bobine du type de la première et disposée verticalement, sous la ligne et perpendiculairement à cette dernière. Cette bobine alimente un deuxième circuit de détection à la fréquence du réseau qui fournit un signal indicatif d'un défaut polyphasé.

En effet, il a été constaté que sur une ligne nappe voûte, certains défauts biphasés en aval qui affectent les phases latérales génèrent un vecteur induction magnétique vertical, la composante horizontale étant nulle. De ce fait, avec un barreau disposé verticalement en dessous de la ligne, la mesure de champ magnétique vertical permet de détecter un défaut polyphasé, même isolé.

Le dispositif de détection de défauts peut comporter un amplificateur recevant le signal fourni par la bobine. Avantageusement cet amplificateur est un amplificateur opérationnel.

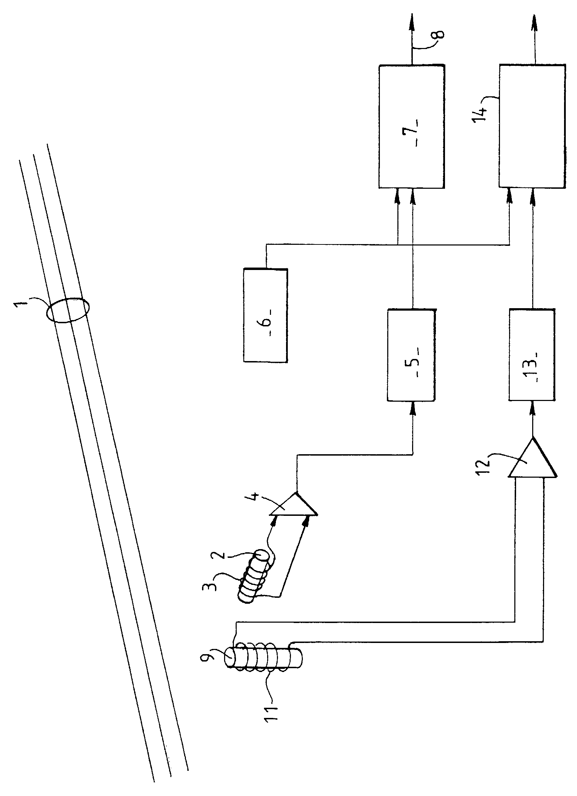

D'autres caractéristiques et avantages de l'invention ressortiront de la description qui suit d'un exemple de réalisation de l'invention, faite en se référant au dessin ci-annexé où la figure unique est un schéma synoptique d'un dispositif de détection de défauts selon l'invention.

Sur la figure on voit une ligne aérienne de distribution d'énergie électrique schématisée en 1 pour laquelle on désire détecter les défauts à la terre qu'ils soient monophasés ou polyphasés.

Le dispositif décrit comporte un premier capteur constitué par un barreau magnétique lisse 2, par exemple ferrite, sur lequel est bobinée une bobine 3. Ce barreau est disposé à proximité de la ligne 1 perpendiculairement à cette dernière, c'est-à-dire perpendiculairement au conducteur aérien de la ligne. Le signal fourni par cette bobine est envoyé sur une forte impédance qui fournit donc une tension qui constitue un signal qui est une image de la dérivée du flux magnétique présent sur la ligne. Ce signal est donc proportionnel à la dérivée du courant homopolaire circulant dans la ligne.

Le signal obtenu est avantageusement amplifié au moyen d'un amplificateur opérationnel 4 dont la sortie est envoyée sur un intégrateur 5 qui fournit une image convenable du courant homopolaire sur une large bande de fréquence, de l'ordre de 40 à 5000Hz, par exemple. Un capteur de champ électrique 6 est disposé également sous la ligne 1. La mesure du champ électrique sous la ligne permet de fournir un signal représentatif de la tension homopolaire de la ligne 1. Ce capteur de tension peut être avantageusement réalisé sur un circuit imprimé à double face.

Le signal fourni par l'intégrateur 5, qui est proportionnel au courant homopolaire et le signal fourni par le capteur 6, qui est proportionnel à la tension homopolaire, sont envoyés sur un circuit électronique 7 de type connu qui effectue une surveillance de la valeur transitoire du courant homopolaire et, en particulier, compare le signe du transitoire de la tension homopolaire et de celui du courant homopolaire. Lorsque les signes de ces deux signaux sont différents, respectivement identiques, ce circuit électronique 7 fournit en 8 un signal indiquant la présence d'un défaut à la terre en aval, respectivement en amont. Ce circuit comporte avantageusement un filtre passe haut dont la fréquence de coupure est par exemple de 100Hz afin d'éliminer la composante principale à 50Hz du courant et de la tension homopolaire. La bande passante est par exemple de 100Hz à 5kHz. De cette manière, on obtient dans chaque canal, courant et tension, le sens de variation relatif du signal.

La comparaison est effectuée à partir du dépassement d'un seuil de la valeur du courant homopolaire. Cette comparaison fournit la direction éventuelle des défauts (amont ou aval). La confirmation du défaut est réalisée par l'existence postérieure à ce courant transitoire, d'une tension homopolaire à 50Hz.

Selon un mode de réalisation de l'invention, on prévoit un deuxième système de détection qui comporte un capteur constitué par un barreau 9 similaire au barreau 2 et sur lequel est enroulée une bobine 11. Le signal de sortie est traité comme le signal de sortie de la bobine 3 à savoir qu'il est envoyé sur une impédance de valeur élevée, amplifié dans un amplificateur opérationnel 12 et envoyé ensuite dans un intégrateur 13.

Les défauts polyphasés étant caractérisés par la présence notable de signaux à 50 Hz, l'analyse transitoire du signal n'est plus nécessaire. On effectue alors une simple mesure de seuil.

En effet, comme indiqué plus haut, les défauts à la terre polyphasés engendrent un champ magnétique vertical à 50 Hz.

Le capteur de tension 6 permet seulement de mesurer une composante liée au déséquilibre géométrique de la ligne, c'est-à-dire représentatif de la tension homopolaire. Il permet également de détecter la réapparition d'une tension triphasée équilibrée directe supérieure par exemple à 4kV dans le cas d'une ligne à 5kV à 50Hz, ce qui signifie que le défaut a été éliminé. Un signal correspondant à cette détection d'une tension triphasée équilibrée est envoyée par le capteur 6 aux deux circuits électroniques 7 et 14 afin de supprimer les signaux d'alarme de défaut.

On voit que l'invention permet de réaliser de manière simple et peu coûteuse un détecteur de défauts qui puisse être fiable à la fois pour les défauts monophasés et polyphasés , même sur des réseaux à haute tension inférieure à 50kV comportant un régime de mise à la terre compensé limitant fortement les courants de défauts. Le détecteur selon l'invention est aussi adapté à tout réseau à mise à la terre centralisée ou même à neutre isolé.

A titre d'exemple, les capteurs de courants peuvent être constitués par un barreau de ferrite lisse de 10mm de diamètre et 120mm de longueur; la bobine est constituée d'environ 6000 spires de fils émaillés de 12 centièmes de millimètre de diamètre bobinées sur une longueur de 100mm. La résistance d'un tel capteur est d'environ 250 Ohms, son inductance est de l'ordre de 1,6 henry et son impédance est respectivement de 550, 9800 et 29400 Ohms à 50Hz, 1kHz et 3kHz.

Le capteur de tension peut être réalisé sur un circuit imprimé double face dont les dimensions sont d'environ 110 x 100mm.

Les circuits électroniques 7 et 14 peuvent comporter deux plages de seuils de détection de courant transitoire telles que 0,5 à 5A et 4 à 40A. La validité de la détection est confirmée par l'existence, par exemple 100ms après le dépassement de seuil par le courant transitoire, d'une tension homopolaire supérieure à un seuil qui peut être réglable, par exemple entre 5 et 50% de la valeur de la tension simple du réseau.

Un tel circuit de détection de type transitoire peut fonctionner avec des capteurs peu précis, en particulier de capteurs tels que décrits plus haut.

Le dispositif de détection de défauts selon l'invention peut être constitué de manière autonome et comporter une alimentation autonome constituée par exemple par des piles au lithium, ce qui lui confère une autonomie de plusieurs années.

## Revendications

1. Dispositif de détection de défauts sur un réseau de distribution d'énergie électrique aérien comportant un circuit électronique (7, 14) qui reçoit un signal représentatif de la tension homopolaire et un signal représentatif du courant homopolaire de la ligne à surveiller, ledit circuit électronique effectuant une détection des variations transitoires du courant homopolaire en comparant le signe de la variation transitoire du courant homopolaire à celui de la variation transitoire de la tension homopolaire, **caractérisé en ce que** le capteur de courant homopolaire est constitué par une bobine (3) comportant un noyau magnétique (2) et disposée sous la ligne à surveiller (1) perpendiculairement à celle-ci, sur un axe horizontal, en ce que le signal fourni par cette bobine est envoyé sur un circuit intégrateur (5) et en ce que le capteur de tension est constitué par un capteur de champ électrique réalisé sur un circuit imprimé et disposé sous la ligne, le capteur de champ électrique permettant seulement de mesurer une composante liée au déséquilibre géometrique de la ligne.

2. Dispositif détecteur de défauts selon la revendication 1, caractérisé en ce qu'il comporte un deuxième capteur de courant homopolaire constitué par une deuxième bobine (11) comportant un noyau magnétique (12) disposée au voisinage de la ligne (1) perpendiculairement à cette dernière et verticalement.

3. Dispositif détecteur de défauts selon les revendications 1 et 2, caractérisé en ce qu'il comporte des amplificateurs (4, 12) recevant chacun le signal fourni par la bobine (3, 11) correspondante.

4. Dispositif détecteur de défauts selon l'une des revendications 1 à 3, caractérisé en ce que le circuit électronique (7, 14) comporte un filtre éliminant la composante fondamentale du courant homopolaire.

5. Dispositif détecteur de défauts selon l'une des revendications 1 à 4, caractérisé en ce que le circuit imprimé est un circuit imprimé double face.

6. Dispositif détecteur de défauts selon la revendication 3, caractérisé en ce que les amplificateurs (4, 12) sont des amplificateurs opérationnels.

7. Dispositif de détection de défauts selon l'une des revendications 1 à 6, caractérisé en ce qu'il comporte une alimentation autonome.

8. Dispositif de détection de défauts selon la revendication 7, caractérisé en ce que l'alimentation autonome est constituée de piles au lithium.

9. Dispositif de détection de défauts selon l'une des revendications 1 et 2, caractérisé en ce que le noyau magnétique est constitué par un barreau lisse en ferrite (2, 9).

## Patentansprüche

1. Vorrichtung zum Detektieren von Fehlern auf einem Freileitungsnetz zur elektrischen Energieverteilung, mit einer elektronischen Schaltung (7, 14), welche ein Signal empfängt, das für die elektrisch symmetrische Spannung repräsentativ ist, und ein Signal, das für den elektrisch symmetrischen Strom der zu überwachenden Leitung repräsentativ ist, wobei die elektronische Schaltung eine Ermittlung von Übergangsveränderungen des elektrisch symmetrischen Stroms durch Vergleichen des Vorzeichens der Übergangsveränderung des elektrisch symmetrischen Stroms mit demjenigen der Übergangsveränderung der elektrisch symmetrischen Spannung bewirkt, dadurch gekennzeichnet, daß der Fühler für den elektrisch symmetrischen Strom aus einer Spule (3) besteht, die einen Magnetkern (2) umfaßt, der unter der zu überwachenden Leitung (1) sowie senkrecht zu dieser auf einer horizontalen Achse angeordnet ist, und daß das durch diese Spule gelieferte Signal auf eine bzw. zu einer Integrationsschaltung (5) geliefert wird, und daß der Spannungsfühler durch einen Fühler für das elektrische Feld gebildet ist, der auf einer gedruckten Schaltung realisiert und unter der Leitung angeordnet ist, wobei der Fühler für das elektrische Feld ausschließlich die Messung einer Komponente erlaubt, die mit der geometrischen Unsymmetrie der Leitung verbunden ist.

2. Detektionsvorrichtung für Fehler nach Anspruch 1, dadurch gekennzeichnet, daß sie einen zweiten Fühler für elektrisch symmetrischen Strom umfaßt, der durch eine zweite Spule (11) gebildet ist, die einen Magnetkern (12) umfaßt, der benachbart zur Leitung (1) senkrecht zu dieser sowie vertikal angeordnet ist.

3. Detektionsvorrichtung für Fehler nach Anspruch 1 oder 2, dadurch gekennzeichnet, daß sie Verstärker (4, 12) umfaßt, die jedes durch die entsprechende Spule (3, 11) gelieferte Signal empfängt.

4. Detektionsvorrichtung für Fehler nach einem der Ansprüche 1 bis 3, dadurch gekennzeichnet, daß die elektronische Schaltung (7, 14) einen Filter umfaßt, welcher die Grundkomponente des elektrisch symmetrischen Stroms beseitigt.

5. Detektionsvorrichtung für Fehler nach einem der Ansprüche 1 bis 4, dadurch gekennzeichnet, daß es sich bei der gedruckten Schaltung um eine doppelseitig gedruckte Schaltung handelt.

6. Detektionsvorrichtung für Fehler nach Anspruch 3, dadurch gekennzeichnet, daß es sich bei den Verstärkern (4, 12) um Operationsverstärker handelt.

7. Detektionsvorrichtung für Fehler nach einem der Ansprüche 1 bis 6, dadurch gekennzeichnet, daß sie eine autonome Stromversorgung umfaßt.

8. Detektionsvorrichtung für Fehler nach Anspruch 7, dadurch gekennzeichnet, daß die autonome Stromversorgung durch Lithiumbatterien gebildet ist.

9. Detektionsvorrichtung für Fehler nach Anspruch 1 oder 2, dadurch gekennzeichnet, daß der Magnetkern durch einen glatten Ferritstab (2, 9) gebildet ist.

## Claims

1. Device for detecting faults on an overhead electric power distribution network incorporating an electronic circuit (7, 14) receiving a signal representing the homopolar voltage and a signal representing the homopolar current of the line to be monitored, the electronic circuit detecting transient variations of the homopolar current by comparing the sign of the transient variant of the homopolar current with that of the transient variation of the homopolar voltage, characterized in that the homopolar current sensor is constituted by a coil (3) having a magnetic core (2) and located beneath the line (1) to be monitored and perpendicular thereto, on a horizontal axis, in that the signal supplied by said coil is transmitted to an integrating circuit (5) and in that the voltage sensor is constituted by an electric field sensor implemented on a printed circuit and placed beneath the line, the electric field sensor only making it possible to measure a component linked with the geometrical unbalance of the line.

2. Fault detecting device according to claim 1, characterized in that it incorporates a second homopolar current sensor constituted by a second coil (11) having a magnetic core (12) positioned in the vicinity of the line (1) perpendicular to the latter and vertically.

3. Fault detecting device according to claims 1 and 2, characterized in that it incorporates amplifiers (4, 12), each of which receives the signal supplied by the corresponding coil (3, 11).

4. Fault detecting device according to one of the claims 1 to 3, characterized in that the electronic circuit (7, 14) incorporates a filter eliminating the fundamental component of the homopolar current.

5. Fault detecting device according to one of the claims 1 to 5, characterized in that the printed circuit is a double-sided printed circuit.

6. Fault detecting device according to claim 3, characterized in that the amplifiers (4, 12) are operational amplifiers.

7. Fault detecting device according to one of the claims 1 to 6, characterized in that it incorporates an autonomous power supply.

8. Fault detecting device according to claim 7, characterized in that the autonomous power supply is constituted by lithium batteries.

9. Fault detecting device according to one of the claims 1 and 2, characterized in that the magnetic core is constituted by a smooth ferrite bar (2, 9).
